# EUROPEAN PATENT SPECIFICATION

(11) **EP 0 523 695 B1**
(45) Date of publication and mention of the grant of the patent: **06.05.1999**
(21) Application number: 92112151.3
(22) Date of filing: 16.07.1992
(51) Int. Cl.: H01J 37/32, C23C 14/34, H01J 37/08, H01J 37/34

(54) **A sputtering apparatus and an ion source**
Sputteranlage und Ionenquelle
Appareillage de pulvérisation cathodique et source d'ions

(30) Priority: 18.07.1991 JP 178116/91; 18.07.1991 JP 178114/91; 18.07.1991 JP 178115/91; 16.08.1991 JP 205906/91; 16.08.1991 JP 205907/91
(43) Date of publication of application: 20.01.1993
(73) Proprietor: MITSUBISHI JUKOGYO KABUSHIKI KAISHA, Tokyo 100 (JP)
(72) Inventor: Yanagi, Kenichi, Hiroshima-shi, Hiroshima-ken (JP); Kato, Mitsuo, Hiroshima-shi, Hiroshima-ken (JP); Tsurusaki, Kazuya, Hiroshima-shi, Hiroshima-ken (JP); Taguchi, Toshio, Hiroshima-shi, Hiroshima-ken (JP); Atarashiya, Kenji, Hiroshima-shi, Hiroshima-ken (JP); Rokkaku, Tadashi, Hiroshima-shi, Hiroshima-ken (JP); Yamashita, Ichiro, Hiroshima-shi, Hiroshima-ken (JP)
(74) Representative: von Hellfeld, Axel, Dr. Dipl.-Phys.

(56) References cited:
- EP-A- 376 017
- EP-A- 0 205 028
- EP-A- 0 339 554
- DD-A- 217 082
- DE-A- 3 920 835
- US-A- 4 841 197

## Description

The invention relates to an ion source for drawing out ions from a discharge plasma for use in an ion apparatus, a sputtering apparatus and a combinatorial apparatus of a sputtering apparatus and an ion source for an ion deposition apparatus, which are suitable for a long object.

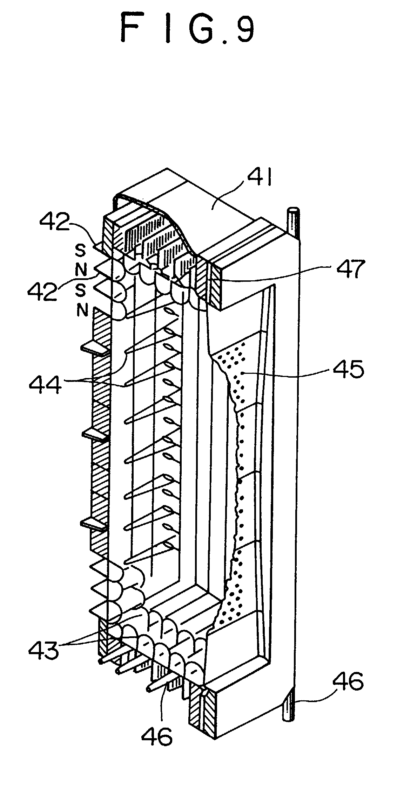

Fig. 9 shows a structure of a conventional ion source. In Fig. 9, numeral 41 denotes an anode electrode in the form of a case, 42 permanent magnets for forming local magnetic fields 43, 44 filament cathodes, 45 an drawing-out electrode for drawing out ions within a plasma producing chamber formed by the anode electrode 41, 46 gas introduction holes for introducing gas required for discharge, and 47 an insulator. The local magnetic fields 43 are formed by the permanent magnets 42 within a wall surface of the plasma producing chamber formed by the anode electrode 41 to generate electric discharge between the anode electrode 41 and the filament cathodes 44. Electrons discharged from the filament cathodes 44 are restrained by means of the magnetic fields 43 to increase the plasma density in the vicinity of the filament cathodes 44 to thereby increase the ion producing efficiency. The gas required for the electric discharge is introduced from the gas introduction holes 46 and ions within the plasma producing chamber is drawn out by a drawing-out electric field applied to the drawing-out electrode 45.

It is well known to use a sputtering apparatus for making a thin-film structure.

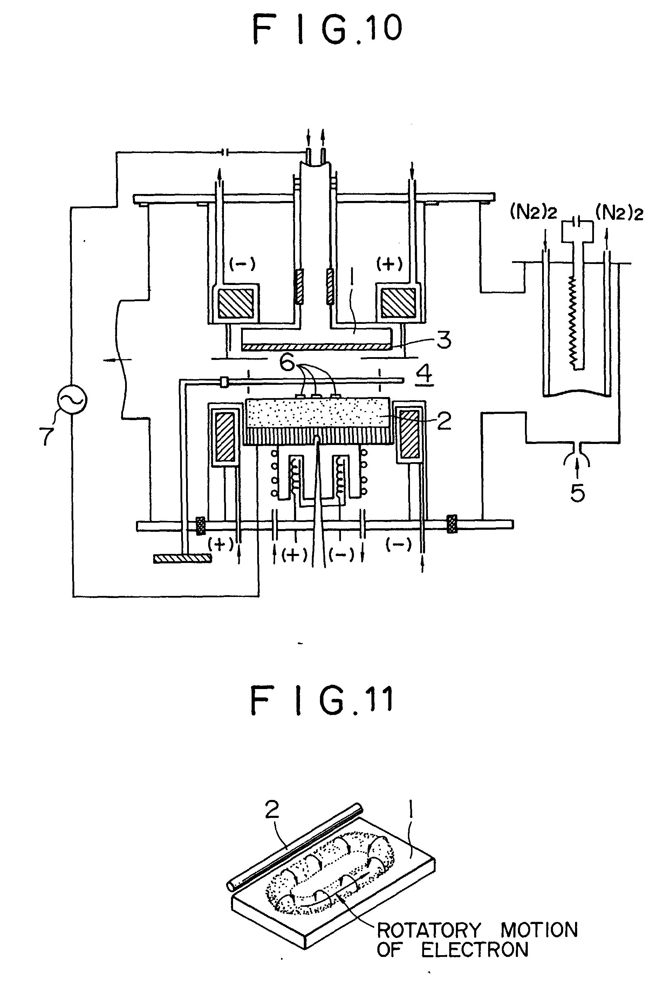

A principle of the sputtering apparatus is now described with reference to Fig. 10. Fig. 10 illustrates a structure of a conventional sputtering apparatus.

In Fig. 10, numerals 1 and 2 denote electrodes. A target 3 is attached to one electrode 1. Gas 5 for sputtering is introduced into a space 4 between the two electrodes I and 2 in vacuum, so that electric discharge is produced between the two electrodes 1 and 2. The introduced gas 5 is ionized and the ionized gas 5 is moved by potential force to be impinged on the target I of the electrode 1. When ions are impinged on the target 3, particles are expelled from the target 3 (sputtering phenomenon). objects 6 to be filmed are attached to the other electrode 2 and the expelled particles from the target 3 are attached on the object 6 to hereby form film on the object 6.

Various contrivances are made to the sputtering apparatus in accordance with application conditions on the basis of the above principle.

The quality of film is often improved when the sputtering phenomenon occurs at low vacuum pressure. However, it is difficult to maintain electric discharge at low vacuum pressure. Accordingly, it is effective to produce a magnetic field by means of a permanent magnet. That is, it is normally practiced that the electron trap operation in an electric discharge area by a magnetic field is utilized to form a structure for maintaining electric discharge at low vacuum pressure (rotatory motion of electron in Fig. 11).

In order to maintain electric discharge between the electrodes 1 and 2 , electric power is supplied to the electrodes 1 and 2 by a power supply 7 as shown in Fig. 10.

There is a problem that when ion irradiation and irradiation of sputtering particles are to be made from the same direction, it is impossible in view of a structural restriction to use the conventional ion source and sputtering apparatus independently.

It is an object of the ion source and the sputtering apparatus as defined in appended claims 1 and 2, respectively, to become capable of forming film on an long object straight.

The hollow cathode having the ion drawing outlet extending in the form of a straight slot is used to produce discharge plasma straight and the straight acceleration electrode is used to accelerate straight ions drawn from the discharge plasma and to accelerate the drawn ion beam with uniform electric field.

It is an object of the sputtering apparatus as defined in claim 3 to become capable of performing ion irradiation and irradiation of sputtering particles simultaneously from the same direction.

Since the ion source and the sputtering apparatus are formed integrally, the ion irradiation and the sputter particle irradiation are made simultaneously from the same direction and a relative angle of irradiation axes of ions and sputter particles can be made fixed at all times. Further, since the ion outlet of the ion source and the sputter particle outlet of the sputtering apparatus are disposed to be directed to the same direction, sputter particles do not enter the ion source. In addition, a vacuum seal apparatus, a cooling apparatus and an anode electrode can be shared.

With reference to the drawings exemplary embodiments of the invention are described.
Fig. 1 is a side view of an ion source according to the present invention;
Fig. 2 is a plan view of an ion source according to the present invention;
Fig. 3 is a circuit diagram of the ion source;
Fig. 4 is a plan view of an ion source in a sputtering apparatus combined integrally therewith according to the present invention;
Fig. 5 is a sectional side view of a sputtering apparatus according to the present invention;
Fig. 6 is a sectional plan view of a sputtering apparatus according to the present invention;
Fig. 7 is a plan view of a sputtering apparatus having an ion source combined integrally therewith according to another embodiment of the present invention;
Fig. 8 is a side view of a sputtering apparatus having an ion source combined integrally therewith according to an embodiment of the present invention;
Fig. 9 is a partially broken perspective view of a conventional ion source;
Fig. 10 is a schematic diagram illustrating a conventional sputtering apparatus; and
Fig. 11 is a diagram schematically illustrating an idea of a planar magnetron type sputtering apparatus;

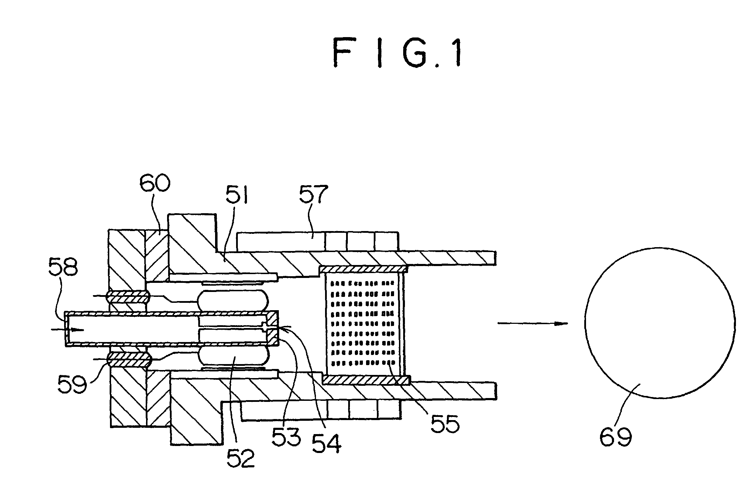

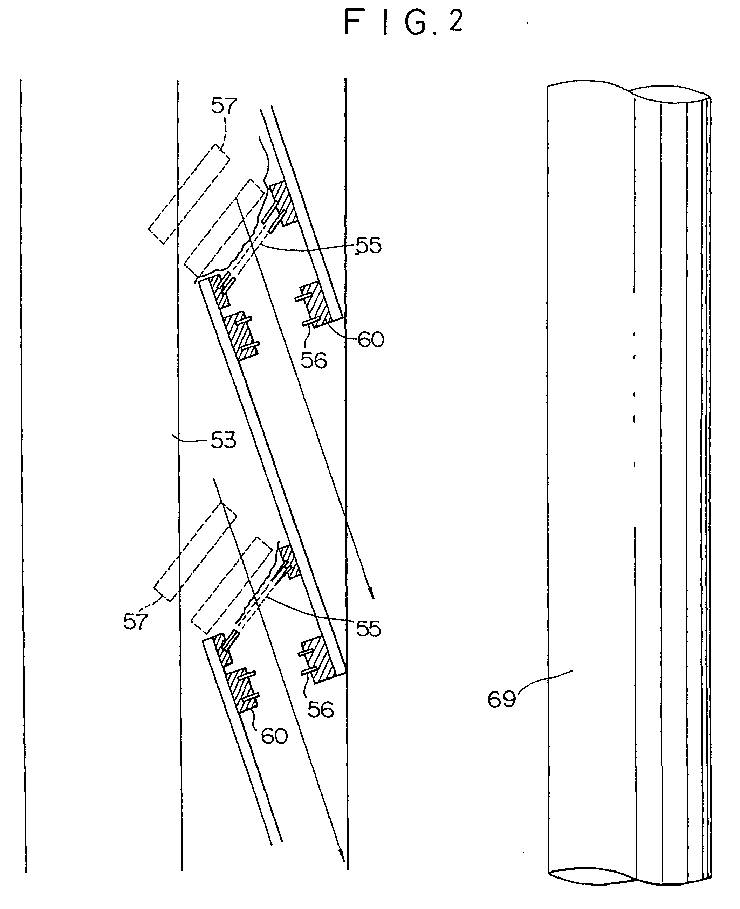

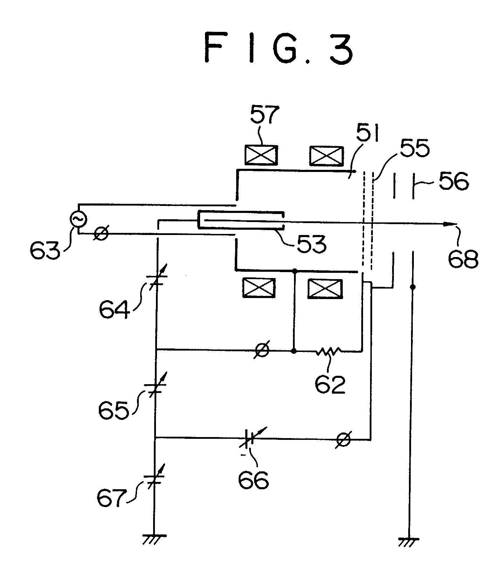

Fig. 1 is a schematic diagram illustrating an ion source according to an embodiment of the first and second inventions, Fig. 2 is a plan view of the ion source of Fig.1, and Fig. 3 is a circuit diagram thereof.

In the figures, numeral 51 denotes an anode electrode to which a hollow cathode 53 is attached through a cathode heater 52. An ion drawing outlet 54 of the hollow cathode 53 extends in the form of straight slot and an ion drawing electrode 55 extending in the form of band is disposed in front of the ion drawing outlet 54. An acceleration electrode 56 for controlling energy of drawn ions is disposed in front of the ion drawing electrode 55 and the acceleration electrode 56 is formed into a slot to match to a shape of the hollow cathode 53. A permanent magnet 57 is disposed outside of the anode electrode 51 as a magnet of the magnetic field producing mechanism to improve uniformity and density of straight discharge plasma by means of the permanent magnet 57. The hollow cathode 53 is provided with a gas introducing hole 58 so that discharge gas is introduced into the hollow cathode 53 from the gas introducing hole 58. In Fig. 1, numeral 59 denotes a heater current introducing terminal, 60 an insulator. In Fig. 3, numeral 62 denotes a starting resistor, 63 a heater current, 64 a discharge power source, 65 a beam energy supply power source, 66 an ion drawing power source, 67 an ion acceleration power supply, and 68 an ion beam.

The above-described ion source can cope with a long object 69. When discharge gas is introduced into the hollow cathode 53 having the ion drawing outlet 54 in the form of straight slot through the gas introduction hole 58, the hollow cathode 53 is heated by the cathode heater 52 at the same time and is supplied with electrons by discharge between the anode electrode 51 and the hollow cathode 53 so that the discharge between the anode electrode 51 and the hollow cathode 53 is maintained by means of electrons.

Since the ion drawing outlet 54 of the hollow cathode is formed into a band, straight band-shaped electrons are supplied to produce plasma in the form of band. Ions in the form of band are drawn out from the band-shaped plasma by means of the drawing electric field applied to the ion drawing electrode 55. When it is necessary to increase energy of ions for processing the long object 69, an acceleration electric field can be applied to the acceleration electrode 56 disposed immediately after the ion drawing electrode 55 to obtain a predetermined ion energy. The acceleration electrode 56 can accelerate ion beam in the form of band effectively by the provision of band-shaped hole. A circuit configuration of the ion source is shown in Fig. 3.

In the above ion source, uniform band-shaped ion beam can be obtained stably for a long time by the provision of the hollow cathode 53 having a slot-shaped ion drawing outlet 54, the acceleration electrode 56 in the form of slot and the permanent magnet 57 and ions can be accelerated without another separate provision of acceleration system.

The band-shaped ion drawing structure from DC discharge plasma has been shown by way of example, the band-shaped ion drawing acceleration can be made even by discharge using a high frequency (for example, ECR).

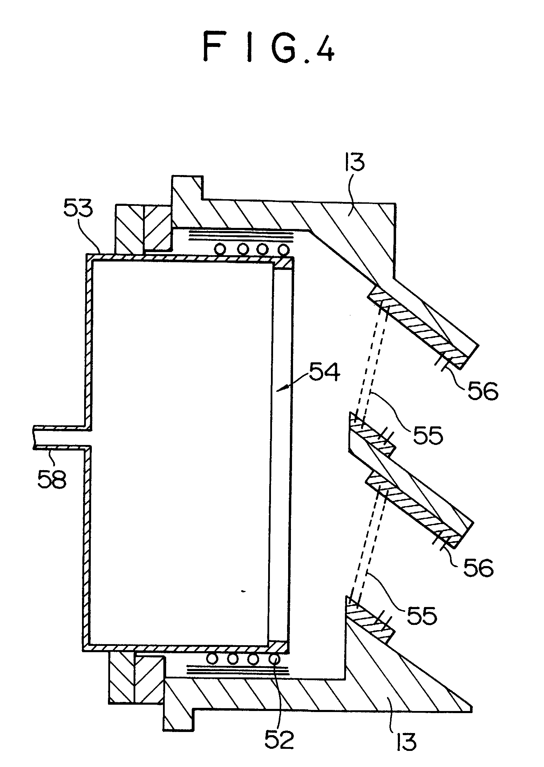

When the long object 69 is desired to be irradiated by ion beam with a fixed angle, as an advantageous feature of the present invention the ion drawing electrode 55 and the acceleration electrode 56 can be inclined as shown in Figs. 1 and 2 if there is no room in disposition space of a vacuum apparatus. In Figs. 1 and 2, by shifting a phase between two ion drawing electrodes 55, ions having a fixed angel with respect to a drawing plane can be drawn. It shall be noted that the ion drawing out angle is changeable as shown in Fig. 4.

Since the ion source of the present invention comprises the hollow cathode having the ion drawing outlet extending in the form of straight slot and the straight acceleration electrode matched to a shape of the hollow cathode provided to control energy of drawing ions, straight discharge plasma is produced and the life of the electrode is lengthened, so that straight ions drawn from discharge plasma can be accelerated.

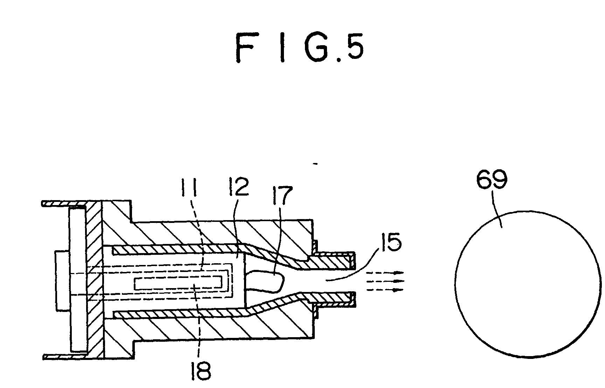

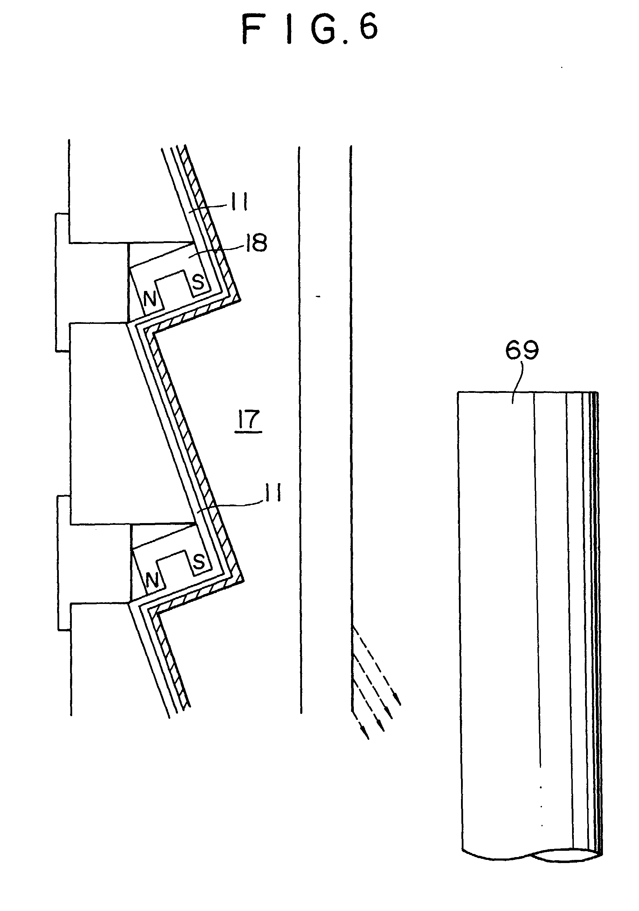

Fig. 5 is a sectional side view of a sputtering apparatus according to an embodiment of a fourth invention, and Fig. 6 is a sectional plan view of Fig. 5.

In the figures, numeral 11 denotes one of electrodes which is provided with a band-shaped target 12. The other electrode 13 is formed into a box to enclose the target 12, and an insulator 14 is disposed between the electrode 13 and the target 12.

A sputtering outlet opening of the electrode 13 disposed in the opposite side of the electrode to interpose the target 12 between the electrodes 11 and 13 is formed to make narrow and have a small area as shown in Fig. 5. The target 12 is formed with an introduction inlet 16 and sputtering gas is introduced into a box-shaped space 17 enclosed by the electrode 13 between the target 12 and the opening 15 through the introduction inlet 16. Thus, vacuum pressure within the box-shaped space 17 is maintained high.

A permanent magnet is disposed as a magnet in the opposite side of the target 12 to interpose the electrode 11 between the permanent magnet 18 and the target 12 so that a magnetic field is produced in a portion of the electrode 11 in which the target 12 is disposed by the permanent magnet 18. The magnet is not limited to the permanent magnet 18 and an electromagnet can be used therefor.

The electrodes 11 and 13 are supplied with electric power by an external power supply 19.

In the sputtering apparatus as structured above, the target 12 is formed into a band and the other electrode 13 is disposed to enclose the target 12, so that the long object 69 can be sputtered straightly. By making small the area of the opening 15, pressure within the box-shaped space 17 can be made higher than pressure of a portion in which the object 20 is disposed and atmospheric pressure of the object 20 is maintained to low. Magnetic field is produced in the target 12 by the permanent magnet 18 to rotate electrons, so that discharge at low pressure can be maintained.

A length of the electrode 11 or the target 11 is set to be 0.7 m and the area of the opening 15 forming an outlet of sputter particles is made small, so that sputtering can be made with the atmospheric pressure of 0.0133 Pa (10⁻⁴Torr) or less. In this case, the magnetic flux density in the vicinity of the electrode 11 of the target 12 is 0.02 T (200 gausses) or more when the permanent magnet 18 is used.

In Fig. 5, the target 12 and the electrode 11 are covered by the insulator 14, while the target and the insulator in combination shown in Table 1 can used by using an AC type or a DC type power supply as the power supply.

**Table 1**

| Covering Material Target | Metal | Insulator |
|---|---|---|
| Metal | DC Power Supply | AC Power Supply |
| Insulator | AC Power Supply | AC Power Supply |

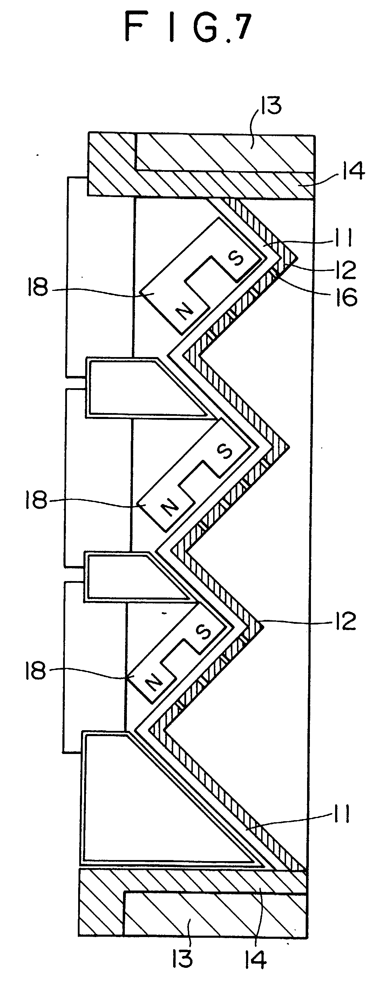

Further, when there is not sufficient space room for installing a sputtering apparatus to sputter a long object in the sputtering apparatus, the electrode 11 and the target 12 can be formed stepwise as shown in Fig. 4 to install the long object. This is an advantage of the present invention. The moving directions of the sputtering particles can be changed by a structure of sputtering apparatus shown in Fig. 7.

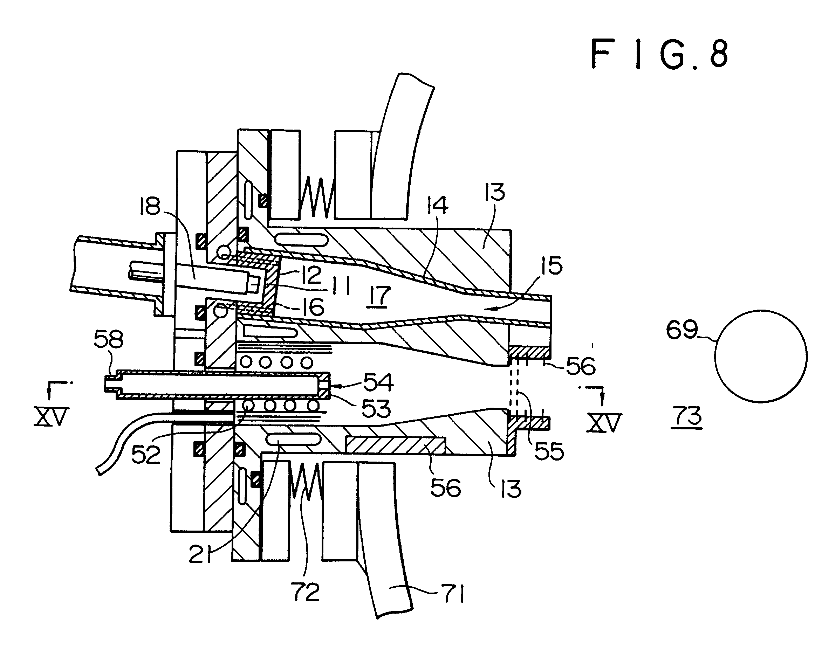

Fig. 8 is a side view of a sputtering apparatus having an ion source combined integrally therewith according to a further embodiment of the invention.

Just as the ion source incorporating sputtering apparatus having a structure shown in Figs. 1, 2, 4, 5, 6, so the ion source incorporating sputtering apparatus having a structure as shown in Fig. 8 can incline the direction of the ions and the sputtering particles, to make a thin layer on a long object.

In the sputtering apparatus having the ion source combined integrally therewith, ion irradiation and sputter particle irradiation can be made simultaneously from the same direction and a relative angle of irradiation axes of ions and sputter particles can be always made fixed, so that proper filming condition can be established. Further, since the ion outlet of the ion source and the sputter particle outlet of the sputtering apparatus are disposed to be directed to the same direction, sputter particles do not enter the ion source and the ion source is not contaminated. The vacuum seal apparatus, the cooling apparatus or the anode electrode 13 can be shared.

The ion sources and the sputtering apparatus according to the present invention are usable separately, However, the sputtering apparatus having the ion source combined integrally therewith of the present invention, the irradiation openings of the ion source and the sputtering apparatus are disposed adjacent to each other and integrated, is advantageous for a long object.

## Claims

1. An ion source for drawing out ions from a discharge plasma comprising:
a cathode (53) and an anode (13) or two electrodes (53, 13) in a vacuum, a gas supplying means for supplying gas in the vacuum, a direct current or high frequency power supply connected to the cathode (53) and the anode (13) or the electrodes (53, 13), an ion drawing electrode (55) for drawing out ions from a discharge plasma generated between the cathode (53) and the anode (13) or the two electrodes (53, 13) for supplying ions on an object substrate (20),
characterized in that
the cathode or electrode (53) has a hollow space, said gas supplying means is arranged to the cathode or electrode (53) as a gas introducing hole (58) for introducing gas into the hollow space, the cathode or electrode (53) has an ion drawing outlet (54) for drawing out ions from the hollow space by attracting them using the ion drawing electrode (55), the ion drawing electrode (55) and the acceleration electrode (56) are disposed obliquely against the direction of the axis of the ion drawing outlet (54), so that the ions go out obliquely the ion outlet (54).

2. A sputtering apparatus comprising:
two electrodes (11, 13) in a vacuum, a gas supplying means for supplying gas in the vacuum, a direct current or high frequency power supply connected to said electrodes for generating an electric discharge in the vacuum, and a target (12) disposed between the electrodes (11, 13), electrons in the electric discharge impact the target (12) to cause a sputtering to deposit sputter particles on an object substrate (20),
characterized in that
the target (12) is formed as a long band and one side thereof is faced to one electrode (11) of the electrodes (11, 13), the other electrode (13) encloses the target (12) so that the other side of the target and the other electrode (13) form a box shaped space (17), the space (17) has a narrow slot-like outlet opening (15), the electrode (11) and the target (12) are arranged stepwise so that the sputter particles go out the opening (15) obliquely against the normal direction of the opening (15), and
permanent magnets (18) are arranged near the one electrode (11) so that a rotational movement is superposed on the movement of electrons near the target (12).

3. A combinatorial apparatus of a sputtering apparatus and an ion source
characterized in that
the sputtering apparatus is an apparatus according to claim 2, the ion source is a source according to claim 1, and
they are arranged one on another so that the sputter particles from the sputtering apparatus and ions from the ion source are irradiated on a surface of object substrate from substantially the same direction.

## Patentansprüche

1. Eine Ionenquelle zum Extrahieren von Ionen aus einem Entladungsplasma, mit:
einer Kathode (53) und einer Anode (13) oder zwei Elektroden (53, 13) in einem Vakuum; einer Gaszufuhrvorrichtung zur Zufuhr von Gas in das Vakuum; einer Gleichstrom- oder Hochfrequenz-Energieversorgung, die mit der Kathode (53) und der Anode (13) oder den Elektroden (53, 13) verbunden ist; einer Ionen-Extrahierelektrode (55) zum Extrahieren von Ionen aus einem zwischen der Kathode (53) und der Anode (13) oder den zwei Elektroden (53, 13) erzeugten Entladungsplasma, um Ionen auf ein Objektsubstrat zu liefern,
dadurch gekennzeichnet, daß:
die Kathode oder Elektrode (53) einen Hohlraum hat; die Gaszufuhrvorrichtung an der Kathode oder Elektrode (53) als Gaseinbringöffnung (58) zum Einbringen von Gas in den Hohlraum angeordnet ist; die Kathode oder Elektrode (53) einen Ionen-Extrahierauslaß (54) aufweist zum Extrahieren von Ionen aus dem Hohlraum durch deren Anziehung unter Verwendung der Ionen-Extrahierelektrode (55); und die Ionen-Extrahierelektrode (55) und eine Beschleunigungselektrode (56) schräg gegen die Richtung der Achse des Ionen-Extrahierauslasses (54) angeordnet sind, so daß die Ionen den Ionenauslaß schräg verlassen.

2. Eine Sputtervorrichtung mit:
zwei Elektroden (11, 13) in einem Vakuum; einer Gaszufuhrvorrichtung zur Zufuhr von Gas in das Vakuum; einer Gleichstrom- oder Hochfrequenz-Energieversorgung, die mit den Elektroden verbunden ist, um in dem Vakuum eine elektrische Entladung zu erzeugen; und einem Ziel (12), das zwischen den Elektroden (11, 13) angeordnet ist, wobei Elektronen in der elektrischen Entladung auf das Ziel (12) auftreffen, um einen Sputter-Effekt zu bewirken, so daß Sputter-Partikel auf einem Objektsubstrat (20) abgeschieden werden
dadurch gekennzeichnet, daß:
das Ziel (12) als langgestrecktes Band ausgebildet ist und eine Seite hiervon einer Elektrode (11) der Elektroden (11, 13) gegenüberliegt, wobei: die andere Elektrode (13) das Ziel (12) umschließt, so daß die andere Seite des Ziels und die andere Elektrode (13) einen schachtelförmigen Raum (17) bilden; der Raum (17) eine enge, schlitzförmige Auslaßöffnung (15) hat; die Elektrode (11) und das Ziel (12) stufenartig angeordnet sind, so daß die Sputter-Partikel die Öffnung (15) schräg zur Senkrechtenrichtung der Öffnung verlassen; und
daß Permanentmagnete (18) nahe der einen Elektrode (11) angeordnet sind, so daß der Bewegung der Elektronen nahe dem Ziel eine Drehbewegung überlagert wird.

3. Eine kombinierte Vorrichtung aus einer Sputtervorrichtung und einer Ionenquelle,
dadurch gekennzeichnet, daß:
die Sputtervorrichtung eine Vorrichtung nach Anspruch 2 ist;
die Ionenquelle eine Quelle nach Anspruch 1 ist; und
daß sie aufeinander angeordnet sind, so daß die Sputter-Partikel von der Sputtervorrichtung und Ionen von der Ionenquelle auf eine Oberfläche eines Objektsubstrates aus im wesentlichen gleichen Richtungen abgestrahlt werden.

## Revendications

1. Source d'ions pour extraire des ions d'un plasma de décharge comprenant :
une cathode (53) et une anode (13) ou deux électrodes (53, 13) dans le vide, un moyen d'alimentation de gaz pour alimenter du gaz dans le vide, une alimentation de courant continu ou à haute fréquence connectée à la cathode (53) et à l'anode (13) ou aux électrodes (53, 13), une électrode d'entraînement d'ions (55) pour extraire des ions d'un plasma de décharge généré entre la cathode (53) et l'anode (13) ou les deux électrodes (53, 13) pour fournir des ions sur un substrat d'objet (20),
caractérisé en ce que
la cathode ou l'électrode (53) possède une cavité, ledit moyen d'alimentation de gaz est disposé sur la cathode ou l'électrode (53) sous la forme d'un trou d'introduction de gaz (58) pour introduire du gaz dans la cavité, la cathode ou l'électrode (53) possède une sortie d'entraînement d'ions (54) pour entraîner des ions hors de la cavité en les attirant à l'aide de l'électrode d'entraînement d'ions (55), l'électrode d'entraînement d'ions (55) et l'électrode d'accélération (56) sont disposées obliquement par rapport à la direction de l'axe de la sortie d'entraînement d'ions (54) de telle façon que les ions sortent obliquement de la sortie d'ions (54).

2. Dispositif de pulvérisation cathodique comprenant :
deux électrodes (11, 13) dans un vide, un moyen d'alimentation en gaz pour alimenter du gaz dans le vide, une alimentation de courant continu ou à haute fréquence connectée auxdites électrodes pour générer une décharge électrique dans le vide, et une cible (12) disposée entre les électrodes (11, 13), des électrons de la décharge électrique frappent la cible (12) pour faire déposer à la pulvérisation cathodique des particules de pulvérisation cathodique sur un substrat d'objet (20),
caractérisé en ce que
la cible (12) a la forme d'une bande allongée et dont l'un des côtés fait face à l'une (11) des électrodes (11, 13), l'autre l'électrode (13) renferme la cible (12) de telle façon que l'autre côté de la cible et l'autre électrode (13) forment un volume en forme de boite (17), le volume (17) possède une ouverture de sortie en forme de fente étroite (15),
l'électrode (11) et la cible (12) sont disposées en gradins de telle façon que les particules de pulvérisation cathodique sortent de l'ouverture (15) obliquement par rapport à la direction normale de l'ouverture (15), et
des aimants permanents (18) sont disposés près de l'une (11) des électrodes de façon à superposer un mouvement de rotation au mouvement des électrons prés de la cible (12).

3. Dispositif combinant un dispositif de pulvérisation cathodique et une source d'ions
caractérisé en ce que
le dispositif de pulvérisation cathodique est un dispositif selon la revendication 2,
la source d'ions est une source selon la revendication 1, et ils sont disposés l'un sur l'autre de telle façon que les particules de pulvérisation cathodique provenant du dispositif de pulvérisation cathodique et les ions provenant de la source d'ions soient irradiées sur une surface de substrat d'objet en provenant sensiblement de la même direction.
